# EUROPÄISCHE PATENTANMELDUNG

(11) **EP 4 456 428 A1**
(43) Veröffentlichungstag der Anmeldung: **30.10.2024**
(21) Anmeldenummer: 23169737.6
(22) Anmeldetag: 25.04.2023
(51) Int. Cl.: H03K 17/97, H01H 9/20

(54) **ANORDNUNG UMFASSEND EIN FUNKTIONSMODUL, EINE DOSE UND EIN SCHALTGERÄT SOWIE VERFAHREN ZUR MONTAGE**

(71) Anmelder: Insta GmbH, 58509 Lüdenscheid (DE)
(72) Erfinder: Schulz, Jakob, 58339 Breckerfeld (DE)
(74) Vertreter: Fobbe, Tobias

(57) **Zusammenfassung**

Zu dem Zweck, eine Anordnung umfassend ein Schaltgerät S, eine Installationsdose D und ein Funktionsmodul F, zu schaffen, bei dem die Zuverlässigkeit der Bedienung des Funktionsmoduls F gegenüber mechanischen Erschütterungen wirksam verbessert ist, wird eine Anordnung vorgeschlagen, wobei das Funktionsmodul F durch die Betätigung eines an dem Schaltgerät S angeschlossenen Betätigungselementes B eines Oberteils O des Schaltgerätes S beeinflussbar ist, wobei das Funktionsmodul F zumindest eine Schnittstelle aufweist, mittels welcher zumindest ein Aktor entsprechend einer Betätigung des Betätigungselementes B ansteuerbar ist, wobei an dem Schaltgerät S mindestens ein Magnet M angeordnet ist, welcher bei Betätigung des Betätigungselementes B seine Position ändert, und wobei das Funktionsmodul F einen Sensor H zur Erfassung des Magnetfeldes MF aufweist, so dass die Änderung des Magnetfeldes MF bei Betätigung des Betätigungselementes B detektiert wird, wobei das Funktionsmodul F eine Auswerteeinheit zur Auswertung der Magnetfeldänderung aufweist, die dazu eingerichtet ist, in Abhängigkeit der sensierten Magnetfeldänderung zu identifizieren, um welche Schaltgeräteart es sich bei dem Schaltgerät S handelt, welche Identifikation in die funktionsmodulseitige Ansteuerung des Aktors einfließt, und wobei das Funktionsmodul F in der Installationsdose D fixierend gegenüber mechanischen Erschütterungen festgelegt ist.

## Beschreibung

Die Erfindung betrifft eine Anordnung umfassend ein Schaltgerät, eine Installationsdose und ein Funktionsmodul, welches Funktionsmodul durch die Betätigung eines an dem Schaltgerät angeschlossenen Betätigungselementes eines Oberteils des Schaltgerätes beeinflussbar ist, wobei das Funktionsmodul zumindest eine Schnittstelle aufweist, mittels welcher zumindest ein Aktor entsprechend einer Betätigung des Betätigungselementes ansteuerbar ist, wobei an dem Schaltgerät mindestens ein Magnet angeordnet ist, welcher bei Betätigung des Betätigungselementes seine Position ändert, und wobei das Funktionsmodul einen Sensor zur Erfassung des Magnetfeldes aufweist, so dass die Änderung des Magnetfeldes bei Betätigung des Betätigungselementes detektiert wird, wobei das Funktionsmodul eine Auswerteeinheit zur Auswertung der Magnetfeldänderung aufweist, die dazu eingerichtet ist, in Abhängigkeit der sensierten Magnetfeldänderung zu identifizieren, um welche Schaltgeräteart es sich bei dem Schaltgerät handelt, welche Identifikation in die funktionsmodulseitige Ansteuerung des Aktors einfließt.

Die Erfindung betrifft ferner ein Verfahren zur Montage einer solchen Anordnung.

Aus AT 525 242 B1 ist ein Funktionsmodul zum Einbau in eine Installationsdose mit einem manuell zu betätigenden Schaltgerät der Gebäudeinstallationstechnik bekannt geworden. Ein solches Funktionsmodul ist durch die Betätigung eines an dem Schaltgerät angeschlossenen Betätigungselementes eines Oberteils des Schaltgerätes beeinflussbar, beispielsweise um Lampen zu schalten, zu dimmen oder um Jalousien zu steuern, und zwar auch fernbedienbar, beispielsweise via Endgerät. Hierzu weist das Funktionsmodul zumindest eine Schnittstelle auf, mittels welcher zumindest ein Aktor entsprechend einer Betätigung des Betätigungselementes ansteuerbar ist, wobei an dem Schaltgerät mindestens ein Magnet angeordnet ist, welcher bei Betätigung des Betätigungselementes seine Position ändert. Ferner weist das Funktionsmodul einen Sensor zur Erfassung des Magnetfeldes auf, so dass die Änderung des Magnetfeldes bei Betätigung des Betätigungselementes detektiert wird. Es versteht sich, dass das Funktionsmodul über ein Endgerät, insbesondere ein mobiles Endgerät, beeinflussbar ist, um auf komfortable Weise bedient werden zu können. Ein solches, vorbekanntes Funktionsmodul umfasst zudem eine Auswerteeinheit zur Auswertung der Magnetfeldänderung, die dazu eingerichtet ist, in Abhängigkeit der sensierten Magnetfeldänderung zu identifizieren, um welche Schaltgeräteart es sich bei dem Schaltgerät handelt, welche Identifikation in die funktionsmodulseitige Ansteuerung des Aktors einfließt, so dass ein Austausch von Schaltern durch Taster vermieden wird. So erfordert das Dimmen einer Lampe mit einem Funktionsmodul beispielsweise eine spezifische Ansteuerung, je nachdem, ob das zugrundeliegende Schaltgerät ein Taster oder ein Schalter ist. Daher ist die Identifikation der Schaltgeräteart durch die Auswerteeinheit ein weiterer Vorteil eines solchen Funktionsmoduls.

Durch ein solches, vorbekanntes Funktionsmodul kann der Installationsaufwand mit Blick auf den zu leistenden Verkabelungsaufwand wie er bei herkömmlichen Funktionsmodulen ohne Sensierung der Magnetfeldänderung erforderlich ist - hierbei werden Kabel zwischen Schaltgerät und Funktionsmodul (nachfolgend fliegende Verkabelung genannt) angeschlossen, um die Betätigung elektrisch zu übermitteln - signifikant verringert werden, da Funktionsmodul und Schaltgerät magnetisch miteinander kommunizieren; ein elektrischer Anschluss des Funktionsmoduls an das Schaltgerät mithin obsolet geworden ist.

Problematisch bei solchen vorbekannten gattungsgemäßen Funktionsmodulen ist jedoch, dass diese hinter ein Schaltgerät in die Installationsdose montiert werden, wobei die magnetische Kommunikationsqualität beeinträchtigt wird, wenn Erschütterungen auftreten, da das Funktionsmodul in der Dose durch die Erschütterungen verrutscht. Ein solches Verrutschen - beispielsweise bedingt durch lautes Musikhören, Vibrationen im Gebäude durch umfallende Gegenstände, Erdbeben oder das einfache Betätigen eines benachbarten Schaltgerätes - führt daher zu unerwünschten Fehlbetätigungen des Schaltgerätes, so dass zum Beispiel eine Lampe eingeschaltet wird, obwohl dies nicht beabsichtigt ist, da der Magnetfeldsensor sich bezüglich des Magneten des Schaltgerätes bewegt, obwohl eine Betätigung des Schaltgerätes gerade nicht vorgenommen wurde. Zudem ist problematisch, dass die Funktionsmodule irgendeine beliebige Position innerhalb der Installationsdose einnehmen, so dass das Signal-zu-Rausch-Verhältnis bezüglich der magnetischen Kommunikation zwischen Magnet und Magnetfeldsensor weder standardisiert noch optimiert ist. In der Praxis hat sich zudem gezeigt, dass das Einsetzen des Funktionsmoduls in die Installationsdose und das nachgelagerte Befestigen des Schaltgerätes an der Installationsdose regelmäßig mit einem erhöhten Installationsaufwand einhergeht, da das Funktionsmodul dazu tendiert, - trotz Einlegens in die Installationsdose - aufgrund von in der Installationsdose unter mechanischen Spannungen stehenden Kabelguts wieder aus der Installationsdose herausgedrückt zu werden. Damit ist die Installation des Schaltgerätes zusammen mit dem Funktionsmodul verkompliziert.

Ausgehend von diesem diskutierten Stand der Technik liegt der Erfindung die Aufgabe zugrunde, eine Anordnung umfassend ein Schaltgerät, eine Installationsdose und ein Funktionsmodul zu schaffen, wobei die vorstehend genannten Nachteile vermieden sind. Insbesondere soll die Zuverlässigkeit der Bedienung des Funktionsmoduls gegenüber mechanischen Erschütterungen wirksam verbessert, gleichzeitig das Signal-zu-Rausch-Verhältnis bezüglich der magnetischen Kommunikation zwischen Magnet und Magnetfeldsensor standardisiert und optimiert werden sowie der Installationsaufwand abgesenkt werden.

Gelöst wird diese Aufgabe durch eine Anordnung umfassend ein Schaltgerät, eine Installationsdose und ein Funktionsmodul, wobei zur Verbesserung der Zuverlässigkeit der Detektion einer Betätigung des Betätigungselementes das Funktionsmodul in der Installationsdose fixierend gegenüber mechanischen Erschütterungen festgelegt ist.

Der Kerngedanke der Erfindung besteht darin, dass bei der erfindungsgemäßen Anordnung das Funktionsmodul fixierend in der Installationsdose festgelegt ist.

Damit wird erfindungsgemäß nicht nur ein unerwünschtes Verrutschen des Funktionsmoduls in Folge von Erschütterungen, beispielsweise durch Betätigung eines benachbarten Schaltgerätes, und damit eine Fehlbetätigung des an das Funktionsmodul angeschlossenen Aktors vermieden, sondern gleichzeitig eine bezüglich der Auswertung der sensierten Magnetfeldänderung durch die Auswerteeinheit optimierten und wohldefinierten Vorzugspositionierung des Funktionsmoduls sichergestellt, so dass ein optimales und zuverlässig erreichbares Signal-zu-Rausch-Verhältnis erreicht wird.

Darüber hinaus wird durch die erfindungsgemäße Anordnung vorteilhafterweise der Installationsaufwand des Funktionsmoduls hinter ein Schaltgerät signifikant verringert, indem das Funktionsmodul in der Installationsdose festgelegt ist, so dass das Funktionsmodul nicht mehr dazu tendiert, aufgrund von in der Installationsdose unter mechanischen Spannungen stehenden Kabelguts wieder aus der Installationsdose herausgedrückt zu werden. Damit ist die Installation des Schaltgerätes zusammen mit dem Funktionsmodul erheblich vereinfacht.

Gemäß einer bevorzugten Weiterbildung der erfindungsgemäßen Anordnung weisen das Funktionsmodul und/oder die Installationsdose ein Fixierungsmittel zur fixierenden Festlegung des Funktionsmoduls in der Installationsdose auf. In einer besonders bevorzugten Ausgestaltung der erfindungsgemäßen Anordnung stellt das Fixierungsmittel eine Federlasche dar, die an das Funktionsmodul und/oder die Installationsdose angeformt ist. Hierdurch wird eine gleichermaßen zuverlässige wie einfache Variante geschaffen, die gewünschte Festlegung des Funktionsmoduls zu schaffen.

In einer bevorzugten Weiterbildung der erfindungsgemäßen Anordnung ist das Funktionsmodul in der Installationsdose fixierend gegenüber mechanischen Erschütterungen festgelegt, indem das Funktionsmodul formschlüssig unter Vorspannung stehend in die Installationsdose eingesetzt ist. Hierbei wird sich auf geschickte Art und Weise die Eigenschaft einer Installationsdose zu Nutze gemacht, dass diese regelmäßig in radiale Richtung leicht federnd ausgelegt ist. Hierdurch ist es besonders einfach und kostengünstig, wenn erfindungsgemäß das Funktionsmodul formschlüssig unter Vorspannung stehend in die Installationsdose eingesetzt ist. Vorteilhafterweise entfällt dabei ein Fixierungsschritt, beispielsweise ein Rasten, Kleben oder dergleichen. Auch kann ein eingesetztes Funktionsmodul besonders einfach wieder entnommen werden.

Gemäß einer besonders bevorzugten Ausgestaltung der erfindungsgemäßen Anordnung weist die Installationsdose Kabeldurchführungsöffnungen auf, wobei das Funktionsmodul unter Ausnutzung der Kabeldurchführungsöffnungen an der Installationsdose festgelegt ist. Eine solche Festlegung kann beispielsweise realisiert sein, indem das Funktionsmodul zwei Federlaschen aufweist, die mit den Kabeldurchführungsöffnungen der Installationsdose, eine mechanische Wirkverbindung herstellend, in Eingriff gestellt sind. Hierdurch wird eine besonders wirksame Festlegung des Funktionsmoduls an der Installationsdose erreicht.

In einer bevorzugten Weiterbildung der erfindungsgemäßen Anordnung ist das Funktionsmodul mit einem Klebstoff an der Installationsdose festgelegt. Ein solcher Klebstoff kann beispielsweise als doppelseitiges Klebeband ausgestaltet sein, so dass der Anwender keinen Klebstoff aufbringen muss.

Gemäß einer bevorzugten Weiterbildung der erfindungsgemäßen Anordnung weist das Funktionsmodul Ausnehmungen auf, die mit Vorsprüngen der Installationsdose, eine mechanische Wirkverbindung herstellend, in Eingriff gestellt sind. Hierdurch kann ein Verrutschen des Funktionsmoduls wirksam vermieden und durch das Schaffen einer Vorzugslage das Signal-zu-Rausch-Verhältnis optimiert werden.

Gemäß einer bevorzugten Weiterbildung der erfindungsgemäßen Anordnung weist das Schaltgerät keine elektrischen Kontakte sowie elektrische Schalter auf. Vielmehr dient ein solches, besonders kostengünstiges Schaltgerät, ausschließlich zur Aufnahme eines Betätigungselementes eines Oberteils. Ein nicht zu unterschätzender, sehr vorteilhafter, positiver Nebeneffekt dabei ist, dass durch den Entfall von elektrischen Kontakten sowie elektrischen Schaltern auf der Rückseite des Schaltgerätes das Signal-zu-Rausch-Verhältnis zusätzlich erheblich verbessert wird, indem das Magnetfeld nicht durch die vorstehenden Komponenten (elektrische Kontakte sowie elektrische Schalter) abgeschwächt wird. Ferner wird hierdurch der Bauraumbedarf des Schaltgerätes innerhalb der Installationsdose weiter reduziert.

Des Weiteren betrifft die Erfindung ein Verfahren zur Montage einer solchen erfindungsgemäßen Anordnung, umfassend die folgenden Schritte:
- Durchführen von Kabelgut zum elektrischen Anschluss des Funktionsmoduls durch mindestens eine Kabeldurchführungsöffnung einer Installationsdose,
- Festlegen der Installationsdose, insbesondere durch Gipsen oder Verschrauben, in einer Gebäudewand,
- Anschluss des Funktionsmoduls an das Kabelgut,
- Festlegendes Einsetzen des Funktionsmoduls in der Installationsdose und
- Montieren des Schaltgerätes.

Durch ein solches Verfahren zur Montage einer solchen erfindungsgemäßen Anordnung wird erreicht, dass die Montage besonders einfach durchführbar ist, insbesondere indem durch das festlegende Einsetzen des Funktionsmoduls in der Installationsdose gerade vermieden wird, dass das möglicherweise unter mechanischen Spannungen stehende Kabelgut das Funktionsmodul aus der Installationsdose herausdrückt beziehungsweise eine für das Signal-zu-Rausch-Verhältnis suboptimale Position eingenommen wird.

Nachfolgend ist der Stand der Technik und die Erfindung unter Bezugnahme auf die beigefügten Figuren anhand diverser Ausführungsbeispiele beschrieben. Es zeigen:
- **Fig. 1:**: eine schematische Seitenansicht einer vorbekannten Anordnung, umfassend ein Schaltgerät, ein Funktionsmodul und eine Installationsdose, wobei das Funktionsmodul eine undefinierte Position aufweist und durch unter mechanischer Spannung stehenden Kabelguts aus der gewünschten Position ausgelenkt wird, so dass der Montageprozess erschwert wird,
- **Fig. 2:**: eine schematische Seitenansicht einer erfindungsgemäßen Anordnung, umfassend ein Schaltgerät, ein Funktionsmodul und eine Installationsdose,
- **Fig. 3:**: eine Draufsicht auf die erfindungsgemäße Anordnung, wobei das Innere des Funktionsmoduls, umfassend eine Leiterplatte, Anschlüsse, eine Funksende-/Empfängereinheit sowie ein Magnetfeldsensor schematisch angedeutet sind,
- **Fig. 4:**: eine schematische, perspektivische Ansicht einer erfindungsgemäßen Anordnung, und
- **Fig. 5:**: eine schematische, perspektivische Ansicht einer erfindungsgemäßen Anordnung, wobei das Funktionsmodul unter Ausnutzung der Kabeldurchführungsöffnungen an der Installationsdose festgelegt ist.

In den verschiedenen Figuren sind gleiche Teile stets mit den gleichen Bezugszeichen versehen und werden daher in der Regel auch jeweils nur einmal benannt beziehungsweise erwähnt.

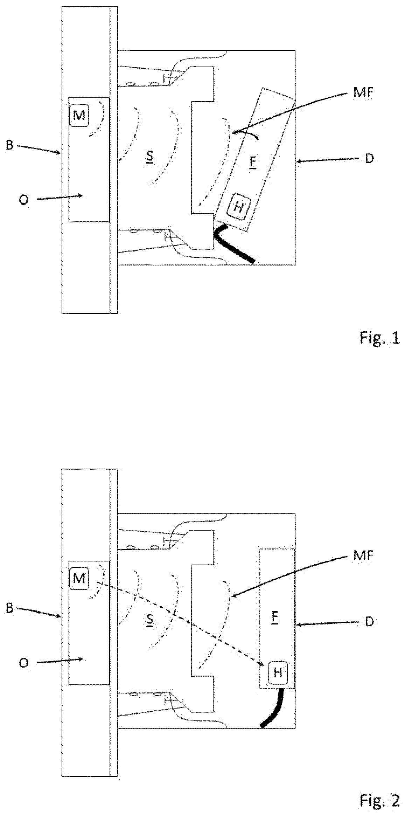

Die in Figur 1 schematisch in einer Seitenansicht dargestellte, aus dem Stand der Technik vorbekannte, Anordnung umfasst ein Schaltgerät S, ein Funktionsmodul F und eine Installationsdose D. Durch eine Betätigung eines an dem Schaltgerät S angeschlossenen Betätigungselementes B eines Oberteils O des Schaltgerätes S ist das Schaltgerät S beeinflussbar, beispielsweise zum Schalten einer Lampe, indem der Sensor H zur Erfassung des Magnetfeldes MF die durch die Betätigung bedingte Änderung des Magnetfeldes MF erfasst. Dabei weist das Funktionsmodul F eine Auswerteeinheit zur Auswertung der Magnetfeldänderung auf, die dazu eingerichtet ist, in Abhängigkeit der sensierten Magnetfeldänderung zu identifizieren, um welche Schaltgeräteart es sich bei dem Schaltgerät S handelt, welche Identifikation in die funktionsmodulseitige Ansteuerung des Aktors einfließt. Ein Schaltgerät S kann beispielsweise ein Schalter, ein Taster oder eine einfache, rein mechanische Wippenaufnahme darstellen. Vorteilhaft bei einem derartigen Funktionsmodul F ist, dass es keine Verkabelung des Funktionsmoduls mit dem Schaltgerät S erfordert. Nachteilig ist jedoch, dass bei einer solchen vorbenannten Anordnung die Zuverlässigkeit der Bedienung des Funktionsmoduls F gegenüber mechanischen Erschütterungen nicht ausreichend sichergestellt ist. Gleichzeitig ist das Signal-zu-Rausch-Verhältnis bezüglich der magnetischen Kommunikation zwischen Magnet M und Sensor H weder standardisiert (jedes Funktionsmodul F liegt mit irgendeiner beliebigen Positionslage in der Installationsdose D) noch optimiert.

Figur 2 zeigt eine schematische Seitenansicht einer erfindungsgemäßen Anordnung, umfassend ein Schaltgerät S, ein Funktionsmodul F und eine Installationsdose D. Bei einer solchen erfindungsgemäßen Anordnung wird sich auf geschickte Art und Weise zu Nutze gemacht, dass zur Verbesserung der Zuverlässigkeit der Detektion einer Betätigung des Betätigungselements B des Schaltgerätes S das Funktionsmodul F in der Installationsdose D fixierend gegenüber mechanischen Erschütterungen festgelegt ist. Eine solche fixierende Festlegung kann erfindungsgemäß beispielsweise durch einen zwischen Installationsdose D und Funktionsmodul F vermittelnden Klebstoff erreicht werden. Bei vorbekannten (nicht gattungsgemäßen) Funktionsmodulen F, insbesondere bei solchen, die eine aufwendige Verkabelung zwischen Schaltgerät S und Funktionsmodul F aufweisen, da sie keinen Magnet M und einen Sensor H zur Erfassung des Magnetfeldes umfassen, sondern elektrisch die Betätigung des Betätigungselementes B an das Funktionsmodul F kommunizieren, stellt sich die Frage der mechanischen Stabilität gegenüber Erschütterungen nicht unmittelbar. Auch stellt sich dort kein Problem bezüglich der Optimierung und/oder Standardisierung eines Signal-zu-Rausch-Verhältnisses bezüglich der detektierten Magnetfeldänderung. Bei gattungsgemäßen Funktionsmodulen F jedoch bestehen derartige Probleme - bei allen existierenden Vorteilen wie geringerer Installationsaufwand und Bauraumbedarf. Insofern löst die erfindungsgemäße Anordnung die vorstehenden Probleme durch eine geschickte Festlegung des Funktionsmoduls F an der Installationsdose D.

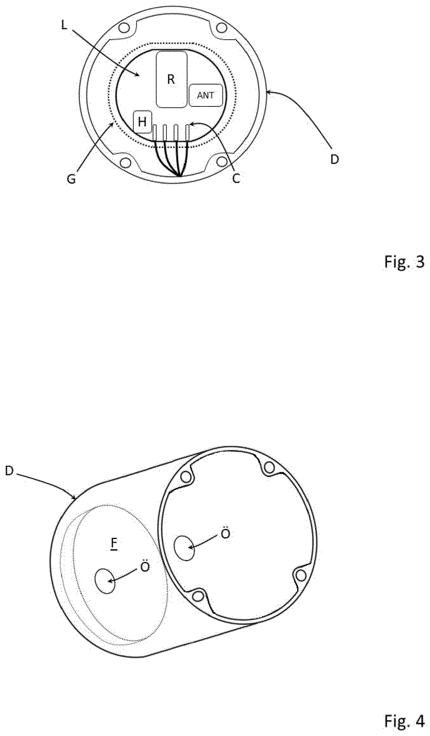

Figur 3 zeigt eine Draufsicht auf die erfindungsgemäße Anordnung, wobei das Innere des ein Gehäuse G aufweisenden Funktionsmoduls F, umfassend eine Leiterplatte L, Anschlüsse C, eine Funksende-/Empfängereinheit ANT sowie ein Sensor H schematisch angedeutet sind. Durch die intelligente Positionierung des ohnehin für die Detektion der mechanischen Betätigung erforderlichen Sensors H innerhalb eines Abstandes von weniger als 4 mm bezüglich der Anschlüsse C wird erreicht, dass die induzierten Ströme zur Energie- und/oder Leistungsmessung herangezogen werden können. Damit kann, ohne zusätzlich Kosten oder Bauraum zu beanspruchen, eine Energie- und/oder Leistungsmessung ermöglicht werden.

In Figur 4 ist eine schematische, perspektivische Ansicht einer erfindungsgemäßen Anordnung gezeigt, wobei das Funktionsmodul F an der Installationsdose D festgelegt ist. Dabei sind ebenfalls Kabeldurchführungsöffnungen Ö der Installationsdose gezeigt.

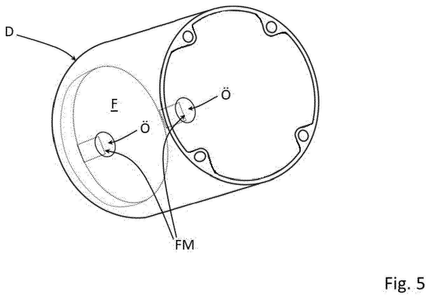

In Figur 5 ist eine schematische, perspektivische Ansicht einer erfindungsgemäßen Anordnung gezeigt, wobei das Funktionsmodul F unter Ausnutzung der Kabeldurchführungsöffnungen Ö an der Installationsdose D festgelegt ist. Dabei weist das Funktionsmodul F zwei Federlaschen FM auf, die mit den Kabeldurchführungsöffnungen Ö der Installationsdose D, eine mechanische Wirkverbindung herstellend, in Eingriff gestellt sind. Hierdurch wird eine besonders zuverlässige Festlegung des Funktionsmoduls F an der Installationsdose D erreicht, die überdies auf einfache Art und Weise geschaffen beziehungsweise wieder aufgehoben werden kann.

### Bezugszeichenliste

- ANT: Funksende-
- B: /Empfängereinheit
- C: Betätigungselement
- D: Anschluss Installationsdose
- F: Funktionsmodul
- FM: Federlasche
- G: Gehäuse
- H: Sensor
- L: Leiterplatte
- M: Magnet
- MF: Magnetfeld
- O: Oberteil
- Ö: Kabeldurchführungsöffnung
- S: Schaltgerät

## Patentansprüche

1. Anordnung umfassend ein Schaltgerät (S), insbesondere einen Schalter oder einen Taster, eine Installationsdose (D) und ein Funktionsmodul (F), welches Funktionsmodul (F) durch die Betätigung eines an dem Schaltgerät (S) angeschlossenen Betätigungselementes (B) eines Oberteils (O) des Schaltgerätes (S) beeinflussbar ist, wobei das Funktionsmodul (F) zumindest eine Schnittstelle aufweist, mittels welcher zumindest ein Aktor entsprechend einer Betätigung des Betätigungselementes (B) ansteuerbar ist, wobei an dem Schaltgerät (S) mindestens ein Magnet (M) angeordnet ist, welcher bei Betätigung des Betätigungselementes (B) seine Position ändert, und wobei das Funktionsmodul (F) einen Sensor zur Erfassung des Magnetfeldes aufweist, so dass die Änderung des Magnetfeldes (MF) bei Betätigung des Betätigungselementes (B) detektiert wird, wobei das Funktionsmodul (F) eine Auswerteeinheit zur Auswertung der Magnetfeldänderung aufweist, die dazu eingerichtet ist, in Abhängigkeit der sensierten Magnetfeldänderung zu identifizieren, um welche Schaltgeräteart es sich bei dem Schaltgerät (S) handelt, welche Identifikation in die funktionsmodulseitige Ansteuerung des Aktors einfließt, **dadurch gekennzeichnet, dass** zur Verbesserung der Zuverlässigkeit der Detektion einer Betätigung des Betätigungselements (B) das Funktionsmodul (F) in der Installationsdose (D) fixierend gegenüber mechanischen Erschütterungen festgelegt ist.

2. Anordnung nach Anspruch 1, **dadurch gekennzeichnet, dass** das Funktionsmodul (F) und/oder die Installationsdose (D) ein Fixierungsmittel (FM) zur fixierenden Festlegung des Funktionsmoduls (F) in der Installationsdose (D) aufweist beziehungsweise aufweisen.

3. Anordnung nach Anspruch 2, **dadurch gekennzeichnet, dass** das Fixierungsmittel (FM) eine Federlasche darstellt, die an das Funktionsmodul (F) und/oder die Installationsdose (D) angeformt ist.

4. Anordnung nach einem der Ansprüche 1 bis 3, **dadurch gekennzeichnet, dass** das Funktionsmodul (F) in der Installationsdose (D) fixierend gegenüber mechanischen Erschütterungen festgelegt ist, indem das Funktionsmodul (F) formschlüssig unter Vorspannung stehend in die Installationsdose (D) eingesetzt ist.

5. Anordnung nach einem der Ansprüche 1 bis 4, **dadurch gekennzeichnet, dass** die Installationsdose (D) Kabeldurchführungsöffnungen (Ö) aufweist, wobei das Funktionsmodul (F) unter Ausnutzung der Kabeldurchführungsöffnungen (Ö) an der Installationsdose (D) festgelegt ist.

6. Anordnung nach Anspruch 5, **dadurch gekennzeichnet, dass** das Funktionsmodul (F) zwei Federlaschen aufweist, die mit Kabeldurchführungsöffnungen (Ö) der Installationsdose (D), eine mechanische Wirkverbindung herstellend, in Eingriff gestellt sind.

7. Anordnung nach einem der Ansprüche 1 bis 6, **dadurch gekennzeichnet, dass** das Funktionsmodul (F) mit einem Klebstoff an der Installationsdose (D) festgelegt ist.

8. Anordnung nach einem der Ansprüche 1 bis 7, **dadurch gekennzeichnet, dass** das Funktionsmodul (F) Ausnehmungen aufweist, die mit Vorsprüngen der Installationsdose (D), eine mechanische Wirkverbindung herstellend, in Eingriff gestellt sind.

9. Anordnung nach einem der Ansprüche 1 bis 8, **dadurch gekennzeichnet, dass** das Schaltgerät (S) keine elektrischen Kontakte sowie elektrische Schalter umfasst, sondern ausschließlich zur Aufnahme eines Betätigungselementes (B) eines Oberteils (O) dient.

10. Verfahren zur Montage einer Anordnung gemäß einem der Ansprüche 1 bis 9, umfassend die folgenden Schritte:
- Durchführen von Kabelgut zum elektrischen Anschluss des Funktionsmoduls (F) durch mindestens eine Kabeldurchführungsöffnung einer Installationsdose (D),
- Festlegen der Installationsdose (D), insbesondere durch Gipsen oder Verschrauben, in einer Gebäudewand,
- Anschluss des Funktionsmoduls (F) an das Kabelgut,
- Festlegendes Einsetzen des Funktionsmoduls (F) in der Installationsdose (D) und
- Montieren des Schaltgerätes (S).

## Geänderte Patentansprüche

### Geänderte Patentansprüche gemäss Regel 137(2) EPÜ.

1. Anordnung umfassend ein Schaltgerät (S) in Form eines Schalters oder eines Tasters, eine Installationsdose (D) und ein Funktionsmodul (F), welches Funktionsmodul (F) durch die Betätigung eines an dem Schaltgerät (S) angeschlossenen Betätigungselementes (B) eines Oberteils (O) des Schaltgerätes (S) beeinflussbar ist, wobei das Funktionsmodul (F) zumindest eine Schnittstelle aufweist, mittels welcher zumindest ein Aktor entsprechend einer Betätigung des Betätigungselementes (B) ansteuerbar ist, wobei an dem Schaltgerät (S) mindestens ein Magnet (M) angeordnet ist, welcher bei Betätigung des Betätigungselementes (B) seine Position ändert, und wobei das Funktionsmodul (F) einen Sensor zur Erfassung des Magnetfeldes aufweist, so dass die Änderung des Magnetfeldes (MF) bei Betätigung des Betätigungselementes (B) detektiert wird, wobei das Funktionsmodul (F) eine Auswerteeinheit zur Auswertung der Magnetfeldänderung aufweist, die dazu eingerichtet ist, in Abhängigkeit der sensierten Magnetfeldänderung zu identifizieren, um welche Schaltgeräteart es sich bei dem Schaltgerät (S) handelt, welche Identifikation in die funktionsmodulseitige Ansteuerung des Aktors einfließt, wobei zur Verbesserung der Zuverlässigkeit der Detektion einer Betätigung des Betätigungselements (B) das Funktionsmodul (F) in der Installationsdose (D) fixierend gegenüber mechanischen Erschütterungen festgelegt ist und dass das Funktionsmodul (F) Ausnehmungen aufweist, die mit Vorsprüngen der Installationsdose (D), eine mechanische Wirkverbindung herstellend, in Eingriff gestellt sind.

2. Anordnung nach Anspruch 1, **dadurch gekennzeichnet, dass** das Funktionsmodul (F) in der Installationsdose (D) fixierend gegenüber mechanischen Erschütterungen festgelegt ist, indem das Funktionsmodul (F) formschlüssig unter Vorspannung stehend in die Installationsdose (D) eingesetzt ist.

3. Anordnung nach einem der Ansprüche 1 oder 2, **dadurch gekennzeichnet, dass** die Installationsdose (D) Kabeldurchführungsöffnungen (Ö) aufweist, wobei das Funktionsmodul (F) unter Ausnutzung der Kabeldurchführungsöffnungen (Ö) an der Installationsdose (D) festgelegt ist.

4. Anordnung nach Anspruch 3, **dadurch gekennzeichnet, dass** das Funktionsmodul (F) zwei Federlaschen aufweist, die mit Kabeldurchführungsöffnungen (Ö) der Installationsdose (D), eine mechanische Wirkverbindung herstellend, in Eingriff gestellt sind.

5. Anordnung nach einem der Ansprüche 1 bis 4, **dadurch gekennzeichnet, dass** das Funktionsmodul (F) mit einem Klebstoff an der Installationsdose (D) festgelegt ist.

6. Anordnung nach einem der Ansprüche 1 bis 5, **dadurch gekennzeichnet, dass** das Schaltgerät (S) keine elektrischen Kontakte sowie elektrische Schalter umfasst, sondern ausschließlich zur Aufnahme eines Betätigungselementes (B) eines Oberteils (O) dient.

7. Verfahren zur Montage einer Anordnung gemäß einem der Ansprüche 1 bis 6, umfassend die folgenden Schritte:
- Durchführen von Kabelgut zum elektrischen Anschluss des Funktionsmoduls (F) durch mindestens eine Kabeldurchführungsöffnung einer Installationsdose (D),
- Festlegen der Installationsdose (D), insbesondere durch Gipsen oder Verschrauben, in einer Gebäudewand,
- Anschluss des Funktionsmoduls (F) an das Kabelgut,
- Festlegendes Einsetzen des Funktionsmoduls (F) in der Installationsdose (D) und
- Montieren des Schaltgerätes (S).
